# EUROPEAN PATENT SPECIFICATION

(11) **EP 4 268 290 B1**
(45) Date of publication and mention of the grant of the patent: **30.04.2025**
(21) Application number: 20838103.8
(22) Date of filing: 23.12.2020
(51) Int. Cl.: H10N 60/01, G06N 10/40

(54) **METHOD FOR SELECTIVELY ETCHING A METAL COMPONENT**
VERFAHREN ZUM SELEKTIVEN ÄTZEN EINES METALLTEILS
PROCÉDÉ DE GRAVURE SÉLECTIVE D'UN COMPOSANT MÉTALLIQUE

(43) Date of publication of application: 01.11.2023
(73) Proprietor: Microsoft Technology Licensing, LLC, Redmond, WA 98052-6399 (US)
(72) Inventor: ZHANG, Hao, Redmond, Washington 98052-6399 (US)
(74) Representative: Page White Farrer
(86) International application number: PCT/EP2020/087828
(87) International publication number: WO 2022/135726

(56) References cited:
- WO-A1-2020/167318
- WO-A1-2021/110275
- GILL S T ET AL: "Selective Area Superconductor Epitaxy to Ballistic Semiconductor Nanowires", ARXIV.ORG, CORNELL UNIVERSITY LIBRARY, 201 OLIN LIBRARY CORNELL UNIVERSITY ITHACA, NY 14853, 20 March 2018 (2018-03-20), XP081074806, DOI: 10.1021/ACS.NANOLETT.8B01534
- SASA GAZIBEGOVIC ET AL: "Epitaxy of advanced nanowire quantum devices", NATURE, vol. 548, no. 7668, 24 August 2017 (2017-08-24), London, pages 434 - 438, XP055422526, ISSN: 0028-0836, DOI: 10.1038/nature23468
- SEBASTIAN HEEDT ET AL: "Shadow-wall lithography of ballistic superconductor-semiconductor quantum devices", ARXIV.ORG, CORNELL UNIVERSITY LIBRARY, 201 OLIN LIBRARY CORNELL UNIVERSITY ITHACA, NY 14853, 28 July 2020 (2020-07-28), XP081728613

## Description

### Background

Topological quantum computing is based on the phenomenon whereby non-abelian anyons, in the form of "Majorana zero modes" (MZMs), can be formed in regions where a semiconductor is coupled to a superconductor. A non-abelian anyon is a type of quasiparticle, meaning not a particle per se, but an excitation in an electron liquid that behaves at least partially like a particle. An MZM is a particular bound state of such quasiparticles. Under certain conditions, these states can be formed close to the semiconductor-superconductor interface in a nanowire formed from a length of semiconductor coated with a superconductor. When MZMs are induced in the nanowire, it is said to be in the "topological regime". To induce this requires a magnetic field, conventionally applied externally, and also cooling of the nanowire to, or below, a temperature that induces superconducting behaviour in the superconductor material. It may also involve gating a part of the nanowire with an electrostatic potential.

By forming a network of such nanowires and inducing the topological regime in parts of the network, it is possible to create a quantum bit (qubit) which can be manipulated for the purpose of quantum computing. A quantum bit, or qubit, is an element upon which a measurement with two possible outcomes can be performed, but which at any given time (when not being measured) can in fact be in a quantum superposition of the two states corresponding to the different outcomes.

To induce MZMs, the device is cooled to a temperature where the superconductor (e.g. aluminium, Al) exhibits superconducting behaviour. The superconductor causes a proximity effect in the adjacent semiconductor, whereby a region of the semiconductor near the interface with the superconductor also exhibits superconducting properties. Topological phase behaviour is induced in the adjacent semiconductor as well as the superconductor. It is in this region of the semiconductor where the MZMs are formed.

Another condition for inducing the topological phase where MZMs can form is the application of a magnetic field in order to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The g-factor refers to the coefficient between the applied magnetic field and the spin splitting. Typically, the magnetic field is applied by an external electromagnet.

The fabrication of heterostructures comprising an aluminium layer arranged on an InAs semiconductor nanowire has been reported [Krogstrup et al., Nat. Mater. 14, 400 (2015)]. Also of interest are devices based on InSb nanowires. InSb has high electron mobility, strong spin-orbit coupling, and a large Landé *g*-factor, which are considered to be useful properties for allowing MZMs to be induced [Op het Veld et al., Communications Physics 3, 59 (2020)].

When fabricating a heterostructure, a metal layer may be grown over the entire surface of the chip. In order to form a usable device, areas of semiconductor which are not covered by metal may be needed, for example to create junctions. There is therefore a need for a method for selectively patterning the metal.

The use of shadow masks to control deposition of the metal layer has been described in e.g. WO2019/099171 A2; US20230106283 A1 and WO2021/112856 A1. The ability to remove metal selectively would be useful in combination with these techniques, for example to allow different devices fabricated on the same chip to be electrically separated to avoid short circuits.

Gill et al (Nano Lett 2018, 18, 10, pp. 6121-6128) discloses the selective-area epitaxy of Al to InSb nanowires.

Gazibegovic et al (Nature, 548, 7668, pp. 434-438) discloses the bottom-up synthesis of quantum devices including nanowire networks.

Heedt et al (arxiv: 2007.14383v1 [cond-mat.mes-hall] discloses the shadow-wall lithography of ballistic semiconductor-superconductor hybrid devices.

WO 2020/167318 A1 discloses a method of fabricating a device, the method comprising: forming portions of electronic circuitry and a shadow wall structure over a substrate, and subsequently depositing a conducting layer over the substrate by angled deposition of a conducting material in at least a first deposition direction at an acute angle relative to the plane of the substrate. The shadow wall structure is arranged to cast a shadow in the deposition, leaving areas where the conducting material is not deposited.

WO 2021/110275 A1, which falls under A. 54(3) EPC, discloses a method of selectively etching a metal component of a workpiece further comprising a ferromagnetic insulator component. The method comprises contacting the metal component with an etchant solution. The etchant solution comprises a basic etchant and a solvent.

### Summary

The present invention provides a method for selectively etching a metal component of a workpiece, according to claim 1. The method comprises: forming a hard mask over the metal component; and etching the metal component using an etchant solution, whereby the hard mask controls the etching; wherein the etchant solution is a basic etchant solution; and wherein the workpiece includes a semiconductor component below the metal component comprising a material of

Formula 1: InAsₓSb₁₋ₓ

where x is in the range 0 to 1. It has been found that by using a basic etchant in combination with a hard mask, high resolution etching of the metal may be made possible and good selectivity may be achieved.

Certain more specific aspects of the invention are set out in the dependent claims.

### Brief Description of the Drawings

To assist understanding of embodiments of the present disclosure and to show how such embodiments may be put into effect, reference is made, by way of example only, to the accompanying drawings in which:
Fig. 1 is a flow chart outlining a method of fabricating a device;
Figs. 2A to 2D are schematic cross-sections of workpieces obtained at the various stages of the method of Fig. 1;
Fig. 3 is a scanning electron microscopy, SEM, micrograph of an example network of nanowires;
Fig. 4 is an SEM micrograph of the product obtained in accordance with Comparative Example 1;
Fig. 5 is an SEM micrograph of the product obtained in accordance with Comparative Example 2;
Figs. 6A and 6B are annotated SEM micrographs of the product obtained in accordance with Comparative Example 3, at different levels of magnification;
Fig. 7 is an annotated SEM micrograph of the product obtained in accordance with Example 1; and
Fig. 8 is an annotated transmission electron microscopy, TEM, micrograph of the product obtained in accordance with Example 1.

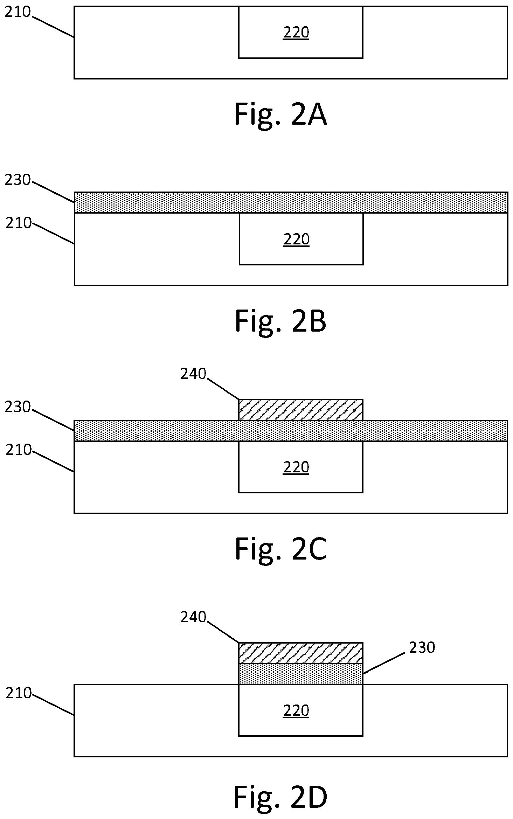

It should be noted that Figs. 2A to 2D are schematic and are not to scale.

### Detailed Description

As used herein, the verb 'to comprise' is used as shorthand for 'to include or to consist of'. In other words, although the verb 'to comprise' is intended to be an open term, the replacement of this term with the closed term 'to consist of' is explicitly contemplated, particularly where used in connection with chemical compositions.

Directional terms such as "top", "bottom", "left", "right", "above", "below", "horizontal" and "vertical" are used herein for convenience of description and relate to the orientation shown in Figs. 2A to 2D. For the avoidance of any doubt, this terminology is not intended to limit orientation in an external frame of reference.

A "nanowire" is an elongate member having a nano-scale width, and a length-to-width ratio of at least 100, or at least 500, or at least 1000. A typical example of a nanowire has a width in the range 10 to 500 nm, optionally 50 to 100 nm or 75 to 125 nm. Lengths are typically of the order of micrometres, e.g. at least 1 µm, or at least 10 µm.

The term "workpiece" may refer in particular to a partially fabricated device.

"Creep", which may also be referred to as "over-etching" or "mask underrun", is when material covered by the outer edges of a mask is removed by the etchant. The creep distance is the distance from the edge of the mask to the edge of the material after the etch.

"SEM" stands for scanning electron microscopy. "TEM" stands for transmission electron microscopy. "SAG" stands for selective area growth. "VLS" stands for "vapour-liquid-solid", and may, depending on the context, refer to the vapour-liquid-solid process or to a nanowire grown by that process. "TMAH" is tetramethyl ammonium hydroxide. "PMMA" is poly(methylmethacrylate). "IPA" is isopropyl alcohol, i.e. propan-2-ol. MIBK is methyl isobutyl ketone.

The inventors have found that the etching of metals, such as aluminium, in the presence of InSb and similar semiconductor materials is particularly challenging. Good selectivity is desired, i.e., the ability to remove the metal without damaging the semiconductor excessively. High resolution, i.e. a small creep distance underneath the mask used to control the etching, is also desired. As described in the Comparative Examples, various existing etching recipes were trialed and found to be unsatisfactory, in that they had inadequate resolution and, in some instances, destroyed the semiconductor nanowires.

It has been found that by using a hard mask (for example, sputtered SiNₓ) in combination with a basic etchant (for example, an aqueous solution of tetramethyl ammonium hydroxide) metals can be etched in the presence of InSb and the like with good resolution and without destroying the semiconductor.

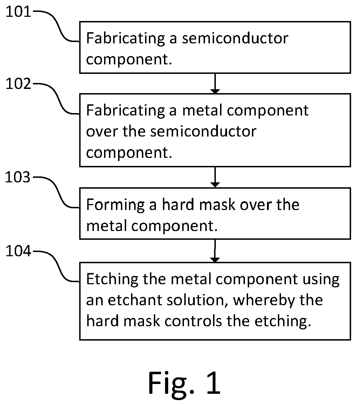

An example method of fabricating a device will now be explained with reference to Figs. 1 and 2. Fig. 1 is a flowchart outlining the method, and Figs. 2A to 2D are schematic cross sections of work pieces obtained at various stages of the method.

The present method may be useful for the fabrication of devices comprising semiconductor-superconductor heterostructures, for example, qubit devices. The method may also be applied to other types of devices comprising a combination of semiconductor and metal components.

At block 101, a semiconductor component is fabricated. The semiconductor component comprises a material of Formula 1:

InAsₓSb₁₋ₓ

where x is in the range 0 to 1. An example of a workpiece obtained at this stage is illustrated in Fig. 2A.

The present method is particularly applicable to indium antimonide. It has been found that indium antimonide is especially susceptible to damage by acidic etchants. Materials according to Formula 1, where x is less than or equal to 0.5, optionally less than or equal to 0.3, optionally less than or equal to 0.25, further optionally less than or equal to 0.1 may be expected to behave similarly to indium antimonide. Materials of Formula 1 where x is less than or equal to 0.3 are expected to behave very similarly to indium antimonide.

The semiconductor component may be fabricated on substrate. The substrate may be any structure on which the device is to be constructed. The substrate typically comprises a wafer, i.e. a piece of single crystalline material. One example wafer material is indium phosphide. Other examples of wafer materials include gallium arsenide, indium antimonide, indium arsenide, and silicon. The substrate may be a more elaborate workpiece, further comprising additional structures arranged on or over the wafer. The substrate may include layers of two or more materials.

The substrate may have a planar surface, and the semiconductor component may be grown epitaxially on the planar surface. Alternatively, the surface of the substrate may include a channel or trench, and the semiconductor component may be grown in the channel or trench. An example is illustrated in Fig. 2a, which shows a wafer 210 and a semiconductor component 220 arranged in a channel in the surface of the wafer 210.

Fabricating the semiconductor component in a channel may allow a workpiece having a substantially planar surface to be obtained. This may make the use of lift-off processes at later stages easier.

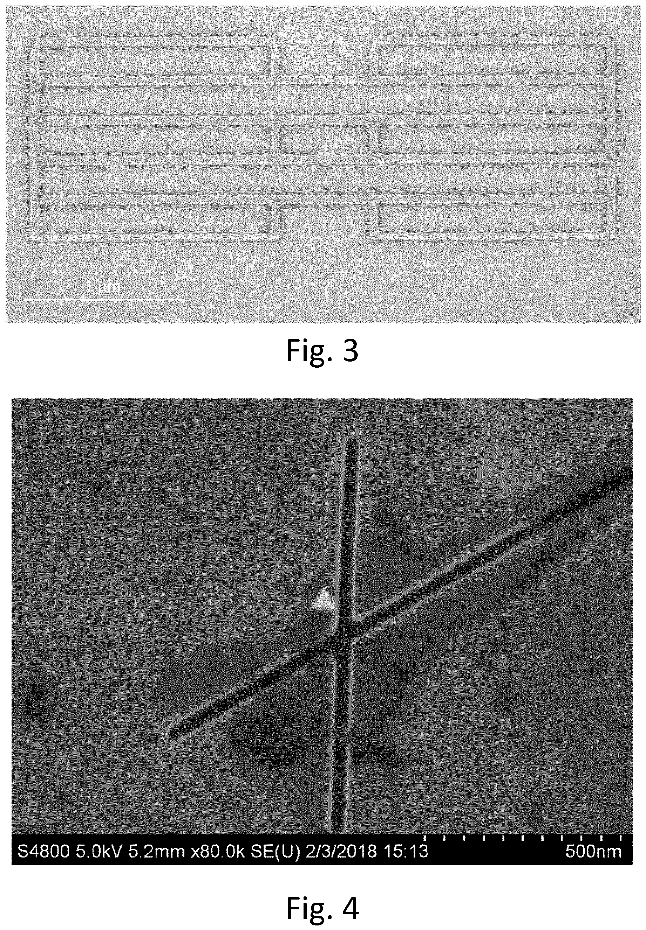

The semiconductor component may comprise a nanowire. In particular, the semiconductor component may take the form of a network of nanowires. A network of nanowires comprises two or more interconnected nanowires. An SEM image of an example network of nanowires is shown in Fig. 3.

In implementations where the semiconductor component comprises a network of nanowires, the nanowires of the network may be grown simultaneously in a single step. Alternatively, the network may be assembled by transferring nanowires from a growth substrate and then subsequently connecting the nanowires together.

The process used to fabricate the semiconductor component is not particularly limited.

One example process for fabricating semiconductor components is selective area growth, "SAG". SAG comprises forming a mask over the substrate, then growing the semiconductor using e.g. molecular beam epitaxy. The mask controls the position at which the semiconductor grows. SAG may be particularly useful for constructing networks of nanowires, since the nanowires and junctions between the nanowires can be conveniently formed at the same time by configuring the openings in the mask appropriately.

Another example process for fabricating semiconductor components is the vapour-liquid-solid, VLS, process. VLS forms vertically orientated nanowires on a growth substrate. By vertically orientated is meant the length direction of the nanowires is perpendicular to the surface of the growth substrate. After growing the nanowires by VLS, the nanowires may be cleaved from the substrate and then positioned that substrate, or transferred to another substrate as desired. Alternatively, the VLS nanowires may remain on the growth substrate, and may be used as components of a vertically-orientated device, such as described in US 2020/0027030 A1 or US 2020/0027971 A1. A network of nanowires may be fabricated by connecting together two or more of VLS grown nanowires.

At block 102, a metal component 230 is fabricated over the semiconductor component. This may yield a workpiece as illustrated in Fig. 2B.

The metal component 230 is typically in the form of a layer. The metal component 230 may be arranged on, e.g., may cover, the surface of the substrate 210 and the semiconductor component 220.

The metal component may have a thickness in the range 2 to 20 nm, optionally 4 to 10 nm.

The process used to form the metal component 230 is not particularly limited. Examples of useful processes include evaporation and molecular beam epitaxy. The metal may be deposited globally, i.e. may cover the surface of the workpiece. Alternatively, the metal may be deposited selectively on selected portions of the surface, for example by using one or more shadow walls to control a directional deposition.

The metal may be any metal which is compatible with the etchant solution discussed below. In other words, the metal is alkali-etchable metal. Etchants for various metals are disclosed in Walker and Tarn (Eds), "Handbook of Metal Etchants", CRC Press, 1991.

The metal may be a superconductor material. For example, the metal may be selected from aluminium, lead, vanadium, and tin. In particular, the metal may be aluminium.

At block 103, a hard mask 240 is formed over the metal component 230. The hard mask 240 covers regions of the metal component 230 where the metal will be present in the finished device, while exposing regions of the metal component 230 which are to be removed. An example workpiece obtained at this stage is shown in Fig. 2C.

The hard mask may comprise any hard mask material which will not react with the etchant solution described below, and which will adhere to the metal. Examples of useful hard mask materials include hafnium oxide, silicon oxide and silicon nitride. In particular, the hard mask material may be silicon oxide or silicon nitride.

The hard mask may be patterned using any suitable process, for example by lift-off.

Lift-off comprises applying a layer of resist over the metal component 230, and then patterning the resist by lithography, typically electron beam lithography. A layer of the hard mask material is then deposited, for example by sputtering. Subsequently, the resist is stripped to yield the hard mask.

The layer of hard mask material may have any appropriate thickness, for example a thickness in the range 15 to 25 nm, optionally about 20 nm.

The resist may comprise poly(methyl methacrylate), PMMA. PMMA is one illustrative example of an electron beam resist. The resist may have a thickness in the range 200 nm to 500 nm.

An example developer for PMMA comprises a mixture of methyl isobutyl ketone ("MIBK") and isopropyl alcohol ("IPA"). The ratio of MIBK to IPA may be 1 : 3 by volume. Acetone may be used to strip the resist.

Other resists, developers, and stripping solvents may be used.

At block 104, the metal component 230 is etched using an etchant solution. The hard mask 240 controls the etch, such that the exposed reasons of the metal component 230 are selectively removed.

The etchant solution is a basic etchant solution. It has surprisingly been found that the use of a basic etchant solution may allow metal such as aluminium to be etched in the presence of semiconductor materials of Formula 1, without excess damage to the semiconductor material. Using a basic etchant in combination with a hard mask may further allow for high-resolution etching to be achieved. It has been found that the etchant creeps under the mask only to a small extent, and that the shape of the edge of the metal component corresponds well to the shape of the edge of the mask.

The etchant solution may comprise, as an active component, a strong base. Examples of strong bases include alkali metal hydroxides such as sodium hydroxide and potassium hydroxide; alkaline earth metal hydroxides such as barium hydroxide; and quaternary ammonium hydroxides such as tetramethyl ammonium hydroxide.

In particular, the etchant solution may comprise tetramethyl ammonium hydroxide as an active component. Tetramethyl ammonium hydroxide was investigated in the examples reported below.

The etchant solution is typically an aqueous solution. The solvent may be water, or a cosolvent mixture including water and one or more further solvents, such as a C1 to C5 alkanol. In other implementations, any other suitable polar, protic solvent may be used. Any solvent which allows the active component to behave as a strong base, i.e. to ionise fully, may be used.

The concentration of the basic etchant is not particularly limited and may be selected as appropriate. For example, the concentration may be in the range 0.2 to 3 M.

The reaction time for the etch may be selected as appropriate depending, for example, the concentration of the etchant, the thickness of the metal component to be etched. Typical reaction times are in the range 40 seconds to 5 minutes. In implementations where the metal is aluminium, the aluminium may remain in contact with the etchant until the silvery colour of the aluminium visibly fades plus about 30 seconds, before terminating the etch.

The etching may be performed at a temperature of up to 25°C, optionally 20 ± 2 °C. By performing the etch at or below room temperature, diffusion of the metal into the semiconductor material and/or damage to the semiconductor by the etchant may be reduced.

The etchant solution is typically agitated during the etch. The agitation may comprise manual agitation or the use of a magnetic stirrer or the like.

The etching may be terminated by rinsing. Rinsing removes residual etchant from the surface of the chip, thereby improving resolution since any residual etchant may continue to etch the metal film and exacerbate creeping under the mask. Examples of solvents useful for rinsing are water and isopropanol. Rapid rinsing may allow for improved resolution, for example, the workpiece or chip may be rinsed in a first rinsing bath for about 5 seconds. Multiple sequential rinsing steps may be performed. For example, the workpiece may be rinsed in three sequential rinsing baths. The solvent in each rinsing bath may be independently selected.

After the etching, further operations may be performed as necessary depending on the nature of the desired device. For example, electrical contacts and/or a protective layer of a dielectric may be added.

It will be appreciated that the above embodiments have been described by way of example only.

### Examples

### Comparative Example 1

A workpiece of the type shown in Fig. 2B was fabricated on an indium phosphide substrate. The semiconductor material was InSb, and the metal was aluminium.

A poly(methylmethacrylate), PMMA, mask was formed over the aluminium. PMMA is an example of a soft polymer mask. After defining an opening in the mask, the aluminium was etched using Transene-D. Transene-D is a commercially available acidic etchant which comprises an aqueous solution of phosphoric acid, sodium *m*-nitrobenzene sulfonate and acetic acid.

The etch was performed at a temperature of 48.1 °C. The reaction time was 14 seconds.

An SEM micrograph of the product is shown in Fig. 4. The SEM image shows that the InSb nanowires were etched away, leaving voids. Further, the edges of the etched region have badly defined, rough edges indicative of uncontrolled creeping of the etchant under the mask.

Transene-D has been reported to give good yields and resolution in indium arsenide / aluminium systems. The present results demonstrate that indium antimonide is much more susceptible to damage by acids than indium arsenide.

Additional experiments were performed using a buffered solution of hydrogen fluoride as the etchant. Buffered hydrogen fluoride is another commercially available acidic etchant for aluminium. This etchant gave very poor resolution, with a high rate of creep under the mask.

### Comparative Example 2

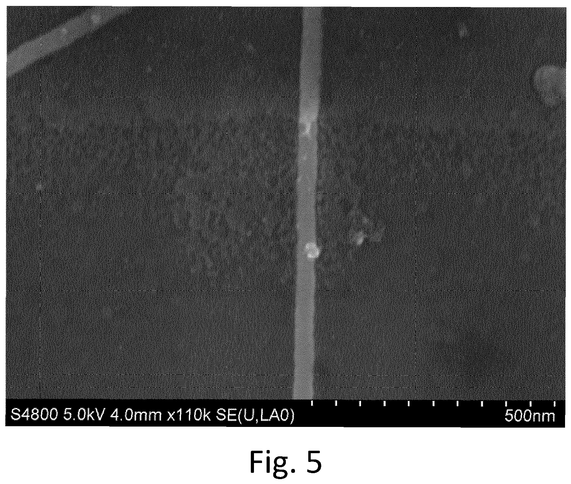

A workpiece was prepared as described above with reference to Comparative Example 1. A PMMA mask was formed over the workpiece. The workpiece was then edged using MF321. MF321 is a commercially available basic etchant solution, which contains 1.91 % tetramethyl ammonium hydroxide by weight as an active ingredient. The reaction time for the etch was 150 seconds. An SEM micrograph of the resulting product is shown in Fig. 5.

As is illustrated in Fig. 5, unlike the acidic etchant of Comparative Example 1, MF321 did not remove the InSb nanowire. However, uncontrolled creeping of the etchant under the mask was observed. The extent of the creep was of the order of a few microns. The edges of the aluminium were uneven and poorly defined.

### Comparative Example 3

An aluminium layer was fabricated on a substrate, and a PMMA mask was applied. The aluminium layer was then etched using aqueous solution comprising 25 % tetramethyl ammonium hydroxide by weight. The reaction time for the etch was 20 seconds.

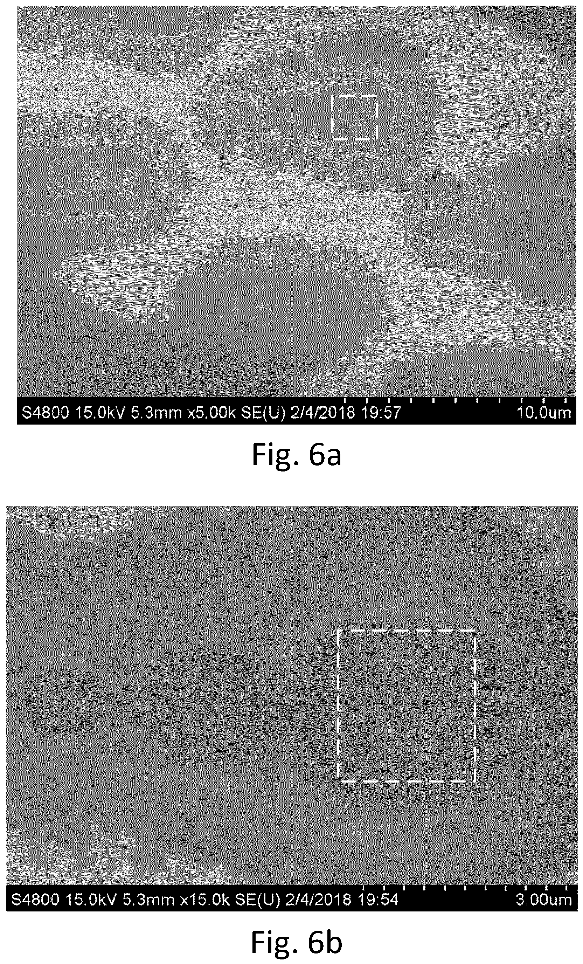

Micrographs of the product at different levels of magnification are shown in Figs. 6a and 6b. The location of one of the etchant windows defined by the mask is shown by dashed lines.

Dark regions of the micrographs correspond to regions where aluminium was removed. Bright regions correspond to regions covered by aluminium. As may be seen, similar to the method of Comparative Example 2, a creeping distance of the order of several microns was observed. The edges of the aluminium again had a poorly defined, irregular shape. These findings demonstrate that adjusting the concentration of the etchant and the reaction time did not solve the problem of creep.

### Example 1

A workpiece of the type shown in Fig. 2b was fabricated. The semiconductor component comprised InSb, and the metal component comprised aluminium.

A PMMA electron beam resist having a thickness in the range 200 to 500 nm was applied to the workpiece, exposed, and developed using a mixture of MIBK and IPA at a ratio of 1 :3 by volume to form a patterned layer of resist. A layer of silicon nitride was then deposited on the workpiece by sputtering, before being formed into a hard mask by lift-off.

The aluminium was etched using an aqueous solution of tetramethyl ammonium hydroxide, TMAH. The TMAH was present at a concentration of 25% by weight of the solution. The reaction time was 3 minutes. The product was then inspected using SEM and TEM.

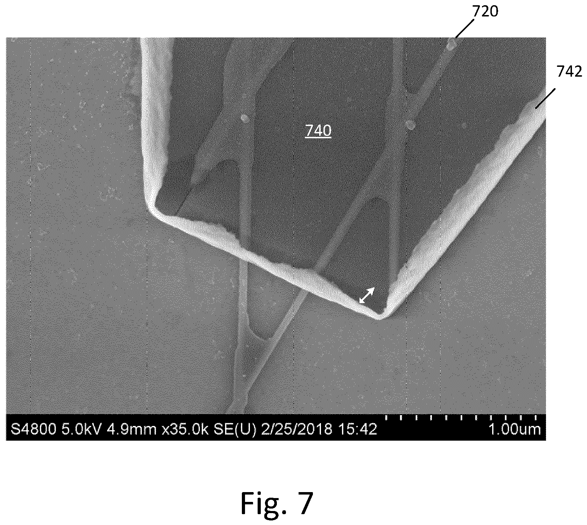

Fig. 7 is an annotated SEM micrograph of the product. The Fig. shows a network of InSb nanowires 720, confirming that the InSb was not removed by the etchant. The dark region 740 corresponds to the silicon nitride hard mask. As is typical for sputtered thin films, the hard mask has a rolled edge 742.

The creeping distance, corresponding to the distance from the visible edge of the aluminium under the mask to the edge of the mask, is shown by the white arrow. The creeping distance was only about 100 nm, demonstrating an improvement in resolution compared to Comparative Examples 2 and 3. Further, the shape of the edge of the aluminium conformed well to the shape of the edge of the mask, showing that the etch was well-controlled.

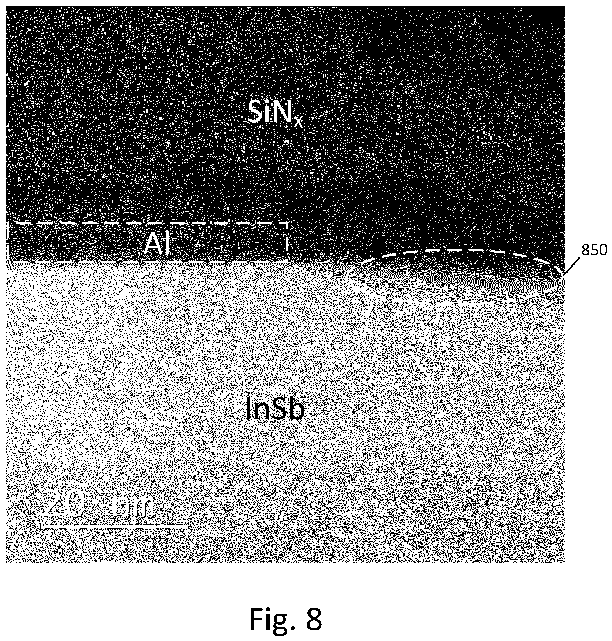

Fig. 8 shows a transmission electron microscopy micrograph of the product, taken through a cross-section of one of the nanowires. Slight degradation to the exposed surface of the InSb nanowire, in the region highlighted by ellipse 850, was observed. The damage did not extend beyond a depth of about 5 nm. This is an acceptable degree of damage, and is comparable to the level of damage caused when etching aluminium on InAs using Transene-D.

Further experiments were performed using MF321 as the etchant solution, a more dilute solution having a TMAH concentration of about 1.91 % by weight. Similar results were obtained.

Other variants or use cases of the disclosed techniques may become apparent to the person skilled in the art once given the disclosure herein.

The creeping distance, corresponding to the distance from the visible edge of the aluminium under the mask to the edge of the mask, is shown by the white arrow. The creeping distance was only about 100 nm, demonstrating an improvement in resolution compared to Comparative Examples 2 and 3. Further, the shape of the edge of the aluminium conformed well to the shape of the edge of the mask, showing that the etch was well-controlled.

Fig. 8 shows a transmission electron microscopy micrograph of the product, taken through a cross-section of one of the nanowires. Slight degradation to the exposed surface of the InSb nanowire, in the region highlighted by ellipse 850, was observed. The damage did not extend beyond a depth of about 5 nm. This is an acceptable degree of damage, and is comparable to the level of damage caused when etching aluminium on InAs using Transene-D.

Further experiments were performed using MF321 as the etchant solution, a more dilute solution having a TMAH concentration of about 1.91 % by weight. Similar results were obtained.

Other variants or use cases of the disclosed techniques may become apparent to the person skilled in the art once given the disclosure herein.

## Claims

1. A method for selectively etching a metal component (230) of a workpiece, which method comprises:
forming (103) a hard mask (240) over the metal component (230); and
etching (104) the metal component (230) using an etchant solution, whereby the hard mask (240) controls the etching;
wherein the etchant solution is a basic etchant solution; and
wherein the workpiece includes a semiconductor component (220) below the metal component (230) comprising a material of
Formula 1: InAsₓSb₁₋ₓ
where x is in the range 0 to 1.

2. The method according to claim 1, wherein the metal component (230) comprises a metal selected from aluminium, lead, vanadium, and tin.

3. The method according to claim 2, wherein the metal is aluminium.

4. The method according to any preceding claim, where x is in the range 0 to 0.25, optionally wherein the semiconductor component comprises indium antimonide.

5. The method according to any preceding claim, wherein the basic etchant solution includes a strong base, optionally wherein the strong base is selected from sodium hydroxide, potassium hydroxide, and tetramethyl ammonium hydroxide.

6. The method according to claim 5, wherein the strong base is tetramethyl ammonium hydroxide.

7. The method according to any preceding claim, wherein the hard mask (240) comprises a material selected from a silicon oxide, a silicon nitride, and a hafnium oxide.

8. The method according to claim 7, wherein the hard mask (240) comprises a silicon nitride.

9. The method according to any preceding claim, wherein the hard mask (240) is formed using sputtering and lift-off.

10. The method according to any preceding claim, wherein the metal component (230) is on the surface of the semiconductor component (220).

11. The method according to any preceding claim, wherein the semiconductor component (220) comprises a nanowire, optionally wherein the semiconductor component (220) comprises a network of nanowires.

12. The method according to any preceding claim, wherein the workpiece further comprises a wafer (210) of crystalline material, and wherein the semiconductor component (220) is on a surface of the wafer (210) or in a channel on the surface of the wafer (210).

13. The method according to claim 12, wherein the crystalline material is indium phosphide.

14. The method according to claim 12 or claim 13, wherein the method further comprises, before forming the hard mask (240):
fabricating (101) the semiconductor component (220); and
subsequently fabricating (102) the metal component (230) over the semiconductor component (220) and the surface of the wafer (210).

15. The method according to claim 14, wherein the semiconductor component (220) is fabricated using selective area growth and/or wherein the metal component (230) is fabricated using molecular beam epitaxy.

## Patentansprüche

1. Verfahren zum selektiven Ätzen eines Metallteils (230) eines Werkstücks, wobei das Verfahren Folgendes umfasst:
Bilden (103) einer Hartmaske (240) über dem Metallteil (230); und
Ätzen (104) des Metallteils (230) unter Verwendung einer Ätzlösung, wobei die Hartmaske (240) das Ätzen kontrolliert;
wobei die Ätzlösung eine basische Ätzlösung ist; und
wobei das Werkstück ein Halbleiterteil (220) unter dem Metallteil (230) einschließt, umfassend ein Material der Formel 1:
InAsₓSb₁₋ₓ
wobei x im Bereich von 0 bis 1 liegt.

2. Verfahren nach Anspruch 1, wobei das Metallteil (230) ein Metall umfasst, das aus Aluminium, Blei, Vanadium und Zinn ausgewählt ist.

3. Verfahren nach Anspruch 2, wobei das Metall Aluminium ist.

4. Verfahren nach einem der vorhergehenden Ansprüche, wobei x im Bereich von 0 bis 0,25 liegt, wobei der Halbleiterteil gegebenenfalls Indiumantimonid umfasst.

5. Verfahren nach einem der vorhergehenden Ansprüche, wobei die basische Ätzlösung eine starke Base einschließt, wobei die starke Base gegebenenfalls aus Natriumhydroxid, Kaliumhydroxid und Tetramethylammoniumhydroxid ausgewählt ist.

6. Verfahren nach Anspruch 5, wobei die starke Base Tetramethylammoniumhydroxid ist.

7. Verfahren nach einem der vorhergehenden Ansprüche, wobei die Hartmaske (240) ein Material umfasst, das aus einem Siliziumoxid, einem Siliziumnitrid und einem Hafniumoxid ausgewählt ist.

8. Verfahren nach Anspruch 7, wobei die Hartmaske (240) ein Siliziumnitrid umfasst.

9. Verfahren nach einem der vorhergehenden Ansprüche, wobei die Hartmaske (240) unter Verwendung von Sputtern und Lift-off gebildet wird.

10. Verfahren nach einem der vorhergehenden Ansprüche, wobei sich das Metallteil (230) auf der Oberfläche des Halbleiterteils (220) befindet.

11. Verfahren nach einem der vorhergehenden Ansprüche, wobei das Halbleiterteil (220) einen Nanodraht umfasst, wobei das Halbleiterteil (220) gegebenenfalls ein Netzwerk aus Nanodrähten umfasst.

12. Verfahren nach einem der vorhergehenden Ansprüche, wobei das Werkstück ferner einen Wafer (210) aus kristallinem Material umfasst und wobei sich das Halbleiterteil (220) auf einer Oberfläche des Wafers (210) oder in einem Kanal auf der Oberfläche des Wafers (210) befindet.

13. Verfahren nach Anspruch 12, wobei das kristalline Material Indiumphosphid ist.

14. Verfahren nach Anspruch 12 oder Anspruch 13, wobei das Verfahren vor dem Bilden der Hartmaske (240) ferner Folgendes umfasst:
Herstellen (101) des Halbleiterteils (220); und
anschließendes Herstellen (102) des Metallteils (230) über dem Halbleiterteil (220) und der Oberfläche des Wafers (210).

15. Verfahren nach Anspruch 14, wobei das Halbleiterteil (220) unter Verwendung von selektivem Flächenwachstum hergestellt wird und/oder wobei das Metallteil (230) unter Verwendung von Molekularstrahlepitaxie hergestellt wird.

## Revendications

1. Procédé de gravure sélective d'un composant métallique (230) d'une pièce, ce procédé comprenant :
la formation (103) d'un masque dur (240) sur le composant métallique (230) ; et
la gravure (104) du composant métallique (230) à l'aide d'une solution de gravure, moyennant quoi le masque dur (240) régule la gravure ;
dans lequel la solution de gravure est une solution basique de gravure ; et
dans lequel la pièce comporte un composant semiconducteur (220) au-dessous du composant métallique (230) comprenant un matériau de formule 1 :
InAsₓSb₁₋ₓ
où x est compris entre 0 et 1.

2. Procédé selon la revendication 1, dans lequel le composant métallique (230) comprend un métal choisi parmi l'aluminium, le plomb, le vanadium et l'étain.

3. Procédé selon la revendication 2, dans lequel le métal est de l'aluminium.

4. Procédé selon l'une quelconque des revendications précédentes, où x est compris entre 0 et 0,25, dans lequel éventuellement le composant semiconducteur comprend de l'antimoniure d'indium.

5. Procédé selon l'une quelconque des revendications précédentes, dans lequel la solution basique de gravure comporte une base forte, dans lequel éventuellement la base forte est choisie parmi l'hydroxyde de sodium, l'hydroxyde de potassium et l'hydroxyde de tétraméthyl-ammonium.

6. Procédé selon la revendication 5, dans lequel la base forte est l'hydroxyde de tétraméthyl-ammonium.

7. Procédé selon l'une quelconque des revendications précédentes, dans lequel le masque dur (240) comprend un matériau choisi parmi l'oxyde de silicium, le nitrure de silicium et un oxyde de hafnium.

8. Procédé selon la revendication 7, dans lequel le masque dur (240) comprend un nitrure de silicium.

9. Procédé selon l'une quelconque des revendications précédentes, dans lequel le masque dur (240) est formé par pulvérisation et par retrait.

10. Procédé selon l'une quelconque des revendications précédentes, dans lequel le composant métallique (230) est à la surface du composant semiconducteur (220).

11. Procédé selon l'une quelconque des revendications précédentes, dans lequel le composant semiconducteur (220) comprend un nanofil, dans lequel éventuellement le composant semiconducteur (220) comprend un réseau de nanofils.

12. Procédé selon l'une quelconque des revendications précédentes, dans lequel la pièce comprend en outre une tranche (210) de matériau cristallin et dans lequel le composant semiconducteur (220) est sur une surface de la tranche (210) ou dans un canal à la surface de la tranche (210).

13. Procédé selon la revendication 12, dans lequel le matériau cristallin est le phosphure d'indium.

14. Procédé selon la revendication 12 ou la revendication 13, le procédé comprenant en outre, avant la formation du masque dur (240) :
la fabrication (101) du composant semiconducteur (220) ; et
la fabrication (102) par la suite du composant métallique (230) sur le composant semiconducteur (220) et la surface de la tranche (210).

15. Procédé selon la revendication 14, dans lequel le composant semiconducteur (220) est fabriqué à l'aide d'une croissance sélective de surface et/ou dans lequel le composant métallique (230) est fabriqué par épitaxie à faisceau moléculaire.
